(19) Europäisches Patentamt
European Patent Office
Office européen des brevets

(11) EP 1 484 380 A1

(12) **EUROPEAN PATENT APPLICATION**
published in accordance with Art. 158(3) EPC

(43) Date of publication:
**08.12.2004 Bulletin 2004/50**

(21) Application number: **03743042.8**

(22) Date of filing: **27.02.2003**

(51) Int Cl.7: **C09K 11/06**, H05B 33/14, C08G 61/12

(86) International application number:
**PCT/JP2003/002206**

(87) International publication number:
**WO 2003/072680 (04.09.2003 Gazette 2003/36)**

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(30) Priority: **28.02.2002 JP 2002054228**

(71) Applicant: **JSR Corporation**
**Tokyo 104-8410 (JP)**

(72) Inventors:
- **ERIYAMA, Yuichi c/o JSR Corporation Chuo-ku, Tokyo 104-8410 (JP)**
- **YASUDA, Hiroyuki c/o JSR Corporation Chuo-ku, Tokyo 104-8410 (JP)**
- **SAKAKIBARA, Mitsuhiko c/o JSR Corporation Chuo-ku, Tokyo 104-8410 (JP)**

(74) Representative:
**Leson, Thomas Johannes Alois, Dipl.-Ing.**
**Tiedtke-Bühling-Kinne & Partner GbR,**
**TBK-Patent,**
**Bavariaring 4**
**80336 München (DE)**

# (54) POLYMERIC PHOSPHORS, PROCESS FOR PRODUCTION THEREOF, PHOSPHORESCENT COMPOSITIONS AND ARTICLES MADE BY USING THE SAME

(57) Disclosed herein are a polymeric phosphorescent agent containing a structural unit represented by the following general formula (1):

General formula (1)

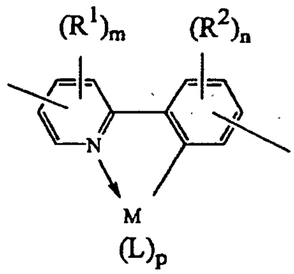

wherein M is a metal atom having a valence of 2 to 4, each of $R^1$ and $R^2$ is, independently, a monovalent substituent selected from a hydrogen atom, halogen atoms, alkyl groups and aryl groups, L is an organic ligand, each of m and n is, independently, an integer of 1 to 3, and p is an integer of 1 to 4, in its molecule and having a molecular weight of at least 500, production process thereof, and a luminescent composition containing such a compound and applied products thereof.

EP 1 484 380 A1

## Description

### TECHNICAL FIELD

The present invention relates to a polymeric phosphorescent agent and a production process thereof, and a luminescent composition and applied products thereof, and particularly to a polymeric phosphorescent agent suitably usable as a material for an organic electroluminescence device produced by an ink-jet method and a production process thereof, and a luminescent composition containing this polymeric phosphorescent agent and applied products thereof.

### BACKGROUND ART

An organic electroluminescence device (hereinafter also referred to as "organic EL device") is expected to be a display device of the coming generation because it has such excellent properties as can be formed into a thin structure, driven by a direct current voltage, is wide in angle of visibility and high in visibility because it is a self-luminescent device, and fast in speed of response, and the researches thereof are actively conducted.

As such organic EL devices, have been known those of a single-layer structure that a luminescent layer composed of an organic material is formed between an anode and a cathode and those of a multi-layer structure such as those of a structure having a hole-transporting layer between an anode and a luminescent layer and those having an electron-transporting layer between a cathode and a luminescent layer. These organic EL devices all emit light by recombination of an electron injected from the cathode with a hole injected from the anode at the luminescent layer.

In such an organic EL device, as methods of forming an organic material layer such as a luminescent layer or hole-transporting layer, have been known a dry method that the organic material layer is formed by vacuum deposition of organic material and a wet method that the organic material layer is formed by applying a solution with the organic material dissolved therein and drying it. Of these, the dry method is difficult to meet mass production because the process thereof is complicated. In addition, there is a limit to the formation of a layer having a large area. On the contrary, the wet method is advantageous compared with the dry method in that the process is relatively simple, and so the method can meet mass production, and an organic material layer having a large area can be formed with ease and high precision by, for example, an ink-jet method.

On the other hand, the organic material layer making up the organic EL device is required to have high luminance and luminous efficiency. Those composed of various materials have heretofore been known, and an organic material layer containing a phosphorescent organoiridium compound or organoosmium compound as a luminescent molecule has recently been proposed (WO 00/70655). This organic material layer is composed of the low molecular organoiridium compound or organoosmium compound alone or of such a compound and a hole-transporting material such as 4,4'-N,N'-dicarbazole biphenyl or 4,4'-bis[N-(1-naphthyl)-N-phenylamino]biphenyl.

Further, in MRS 2000 Fall Meeting (November 27-December 1, 2000, Boston, Massachusetts, USA), a luminescent material composed of a low-molecular iridium compound, polyvinylcarbazole and oxadiazole has been proposed. However, both materials do not satisfy sufficient performance in luminance and luminous efficiency when a luminescent layer is formed from them by a wet method such as an ink-jet method.

### DISCLOSURE OF THE INVENTION

[Problems to be solved by the Invention]

The present invention has been made on the basis of the foregoing circumstances.

It is the first object of the present invention to provide a polymeric phosphorescent agent by which a luminescent layer can be easily formed by a wet method such as an ink-jet method, and an organic electroluminescence device having high luminance can be provided.

The second object of the present invention is to provide a process for producing a polymeric phosphorescent agent by which a luminescent layer can be easily formed by a wet method such as an ink-jet method, and an organic electroluminescence device having high luminance can be provided.

The third object of the present invention is to provide a luminescent composition by which an organic electroluminescence device high in both luminance and luminous efficiency is provided.

The fourth object of the present invention is to provide an organic electroluminescence device high in both luminance and luminous efficiency.

[Means for solving the Problems]

According to the present invention, there is provided a polymeric phosphorescent agent comprising a structural unit represented by the following general formula (1):

General formula (1)

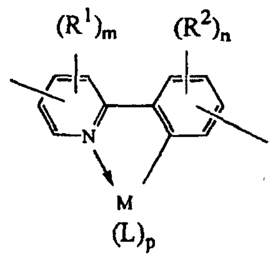

wherein M is a metal atom having a valence of 2 to 4, each of $R^1$ and $R^2$ is, independently, a monovalent substituent selected from a hydrogen atom, halogen atoms, alkyl groups and aryl groups, L is an organic ligand, each of m and n is, independently, an integer of 1 to 3, and p is an integer of 1 to 4, in its molecule and having a molecular weight of at least 500.

The polymeric phosphorescent agent according to the present invention may preferably have a molecular weight of 500 to 50,000.

In the polymeric phosphorescent agent according to the present invention, M indicating the metal atom in the general formula (1) may be a metal atom selected from the group consisting of Pd, Pt, Rh, Ir, Ru, Os and Re.

According to the present invention, there is provided a process for producing the polymeric phosphorescent agent described above, which comprises reacting a polymer having a structural unit represented by the following general formula (2):

General formula (2)

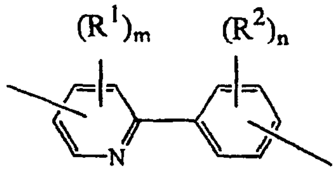

wherein each of $R^1$ and $R^2$ is, independently, a monovalent substituent selected from a hydrogen atom, halogen atoms, alkyl groups and aryl groups, and each of m and n is, independently, an integer of 1 to 3, in its molecule with a metal complex.

In the production process of the polymeric phosphorescent agent according to the present invention, the metal complex may be a mononuclear complex represented by the following general formula (3):

General formula (3)

$$M_x(L)_y(Q)_z$$

wherein M is a metal atom having a valence of 2 to 4, L is an organic ligand, Q is a ligand, the whole or part of which is left by the reaction with the polymer containing the structural unit represented by the general formula (2) in its molecule, x is an integer of 1 to 4, and each of y and z is, independently, an integer of 0 to 8.

In the polymeric phosphorescent agent according to the present invention, the polymer having the structural unit represented by the general formula (2) in its molecule may be obtained by condensation of a pyridine derivative having 2 leaving groups in the presence of a transition metal catalyst and an organic solvent.

According to the present invention, there is provided a luminescent composition comprising the polymeric phosphorescent agent described above, a hole-transporting polymer and an organic solvent.

In the luminescent composition according to the present invention, the hole-transporting polymer may be a copolymer of N-vinylcarbazole and a vinyl-substituted 1-oxa-3,4-diazole compound.

The luminescent composition according to the present invention may be suitable for use in an organic electroluminescence device.

According to the present invention, there is provided an organic electroluminescence device comprising at least an anode layer, a luminescent layer obtained from a material containing the polymeric phosphorescent agent described above and a cathode layer.

The organic electroluminescence device according to the present invention may be obtained by laminating the anode layer, a hole-transporting layer, a copper phthalocyanine layer and the luminescent layer in this order.

The organic electroluminescence device according to the present invention may have a luminescent layer composed of the luminescent composition described above.

According to the present invention, there is provided an organic electroluminescence device obtained through a step of forming a luminescent layer by applying the luminescent composition described above to a surface of a substrate, on which the luminescent layer should be formed, and subjecting the applied composition to a heating treatment.

[Mode for Carrying out the Invention]

The present invention will hereinafter be described in detail.

The polymeric phosphorescent agent according to the present invention comprises an ortho-metallation type metal complex structural unit represented by the general formula (1) in its molecule.

The ortho-metallation type metal complex structural unit is contained at a terminal or in a main

chain of a molecule of the polymeric phosphorescent agent, and may be contained both at the terminal and in the main chain.

The molecular weight of the polymeric phosphorescent agent according to the present invention is at least 500, preferably 500 to 50,000, particularly preferably 1,000 to 30,000 as determined as a weight average molecular weight in terms of polystyrene by means of analysis by gel permeation chromatography (hereinafter abbreviated as "GPC").

If the weight average molecular weight is lower than 500 or exceeds 50,000, it is not preferable since the coating property of such a phosphorescent agent is deteriorated.

In the general formula (1), M is a metal atom having a valence of 2 to 4. More specifically, M is a metal atom selected from the group consisting of Pd, Pt, Rh, Ir, Ru, Os and Re. Among these metal atoms, Ir, Os and Pt are preferred.

Each of $R^1$ and $R^2$ is, independently, a monovalent substituent selected from a hydrogen atom, halogen atoms, alkyl groups and aryl groups and may be the same or different from each other.

The halogen atoms in $R^1$ and $R^2$ include chlorine and fluorine atoms.

The alkyl groups in $R^1$ and $R^2$ include linear, branched or cyclic hydrocarbon groups having 1 to 12 carbon atoms.

The aryl groups in $R^1$ and $R^2$ include aromatic rings having 4 to 14 carbon atoms and monovalent organic groups derived from hetero-atom-containing unsaturated cyclic compounds.

As specific examples of the alkyl groups, may be mentioned methyl, ethyl, propyl, butyl, hexyl, octyl and dodecyl groups.

As specific examples of the aryl groups, may be mentioned phenyl, naphthyl, anthracenyl and biphenyl groups.

As specific examples of the hetero-atom-containing unsaturated cyclic compounds, may be mentioned thiophene, pyrrole, furan, pyridine, pyrimidine, triazine, oxazoline and oxadiazole.

L is an organic ligand and selected from organic compounds having coordination property to the metal atom M.

Each of m and n is, independently, an integer of 1 to 3, and p is an integer of 1 to 4. These m, n and p are each selected in such a manner that it satisfies a stable coordination number in the relation with the valence of the metal atom M and the structural unit of the general formula (1) has a neutral complex structure.

With respect to the relationship between the valence of the metal atom M and the number p of the organic ligands L, the number of outermost shell electrons in the metal atom is selected so as to amount to 16 or 18, and p is selected so as to amount to 1 to 4.

As specific examples of the organic ligand, may be mentioned monodentate organic ligands such as trialkylamines, triarylamines, pyridine, quinoline, oxazole, trialkylphosphines and triarylphosphines, monovalent organic ligands, such as alkoxides such as methoxides, t-butoxides and phenoxides, and carboxylates such as acetates and trifluoroacetates, didentate or still higher organic ligands, such as acetylacetone, hexafluoroacetylacetone, β-diketones such as 5,5-dimethyl-2,4-hexadione, diamines such as ethylenediamine and dipyridyl, 9-hydroxyquinoline, picolinic acid, and salicylic acid, and low-molecular phenylpyridine derivatives having a structural unit of the general formula (2).

These organic ligands may be used either singly or in any combination thereof.

Among these organic ligands, the phenylpyridine derivatives tend to cause dehydration by a reaction of a hydrogen atom located at an ortho-position to the bonding site with the pyridine ring on the phenyl group with a metal atom. As a result, they act as an ortho-metallation type chelating agent that the carbon atom at the ortho-position on the phenyl group is coordinated with the metal atom by a σ-bond, and at the same time, the nitrogen atom on the pyridine ring is coordinated with the metal atom. Therefore, they are preferably introduced for the purpose of stabilizing the resulting polymeric phosphorescent agent and at the same time, controlling wavelength and intensity of phosphorescence.

As specific examples of the phenylpyridine derivatives, may be mentioned 2-phenylpyridine, 2-biphenylpyridine, 2-(2,6-dimethylphenyl)phenylpyridine, 2-phenyl-4-(N,N-dimethylamino)pyridine, 2-phenyl-4-pyrrolidinopyridine, 2-phenyl-4-(N,N-diphenylamino)pyridine, phenyl-4-methylpyridine, 2-phenyl-4,6-dimethylpyridine, 2-(2-fluorophenyl)pyridine, 2-(2,4-difluorophenyl)pyridine, 2-(2,3,4-trifluorophenyl)pyridine, 2-(2,3,4,5-tetrafluorophenyl)pyridine, 2-phenyl-4-methylpyridine, 2-(2-fluorophenyl)-4-methylpyridine, 2-(2,4-difluorophenyl)-4-methylpyridine, 2-(2,3,4-trifluorophenyl)-4-methylpyridine, 2-(2-naphthyl)pyridine, 2-phenylquinoline, 2-benzoylpyridine, 7,8-benzoquinoline, 9-anthranylpyridine, 2-(2-fluorenyl)pyridine, 2-(2-(9,10-dimethyl)fluorenyl)pyridine, 2-(2-(9,10-dihexyl)-fluorenyl)pyridine and 2-(2-(9,10-dioctyl)fluorenyl)-pyridine.

In such a polymeric phosphorescent agent, a peak wavelength of phosphorescence falls within a range of 440 to 700 nm.

Here, as an organic electroluminescence device, is preferably used that whose luminescence wavelength falls within the range of 440 to 700 nm which is the same range as that of the phosphorescence peak wavelength of the polymeric phosphorescent agent according to the present invention.

The polymeric phosphorescent agent according to the present invention is produced by mixing a polymer compound (hereinafter also referred to as "precursor polymer") composed of a polymer having a structural unit represented by the general formula (2) in its molecule with a metal complex (hereinafter also referred to as "precursor metal complex") of a metal atom M (M is

a metal atom having a valence of 2 to 4) in an organic solvent under an inert gas atmosphere and then subjecting the resultant mixture to a reaction under heat in a temperature range of 50 to 300°C for 1 to 12 hours.

Mixing proportions of the precursor polymer and the metal complex are such that the proportion of the metal complex is 0.1 to 100 parts by weight per 100 parts by weight of the precursor polymer.

If the mixing proportion of the metal complex to the precursor polymer is lower than 0.1 parts by weight, the reaction efficiency is lowered. On the other hand, if the mixing proportion of the metal complex to the precursor polymer exceeds 100 parts by weight, the homogeneity of the resulting polymeric phosphorescent agent is deteriorated.

The reaction under heat is conducted in such a manner that the concentration of the reactive compound used in the reaction in a solution of the reaction system amounts to 1 to 50 % by weight in terms of solids.

If the concentration of the reactive compound is lower than 1 % by weight, the reaction efficiency is lowered. On the other hand, if the concentration of the reactive compound exceeds 50 % by weight, the reactive compound is liable to be deposited. It is hence not preferable to conduct the reaction at such a too low or high concentration.

By this reaction, the metal atom of the precursor metal complex is coordinated with the nitrogen atom in the pyridine ring in the structural unit of the general formula (2), and at the same time, the hydrogen atom located at the ortho-position on the phenyl group to the bonding site with the pyridine ring is left to bond the carbon atom related to said hydrogen atom on the phenyl group to the metal atom, thereby forming the structural unit of the general formula (1).

In the reaction system for obtaining the structural unit of the general formula (1), nitrogen, argon or the like is used as the inert gas, and an organic compound having a boiling point of 50 to 300°C under atmospheric pressure is used as the organic solvent.

As specific examples of the organic solvent, may be mentioned alcohols such as butanol; octanol, ethylene glycol, propylene glycol, ethylene glycol monomethyl ether, propylene glycol monomethyl ether, ethylene glycol monoethyl ether, propylene glycol monoethyl ether, ethylene glycol monobutyl ether and propylene glycol monobutyl ether, aromatic hydrocarbons such as toluene, xylene and mesitylene, esters such as ethyl acetate, butyl acetate, ethoxypropylene glycol acetate and $\gamma$-butyrolactone, amides such as N-methylpyrrolidone, formamide, dimethylformamide and dimethylacetamide, ethers such as ethylene glycol dimethyl ether, diethylene glycol dimethyl ether, tetrahydrofuran and 1,4-dioxane, and ketones such as cyclohexanone, methyl amyl ketone and methyl isobutyl ketone.

The organic solvent is suitably selected from among the above-mentioned solvents on the basis of the solubility of the polymer. However, the aromatic hydrocarbons, amides, ethers and ketones are preferably used.

The precursor polymer is a precursor of the polymeric phosphorescent agent having the structural unit of the general formula (1), or a polymeric ligand which will become the polymeric phosphorescent agent by the reaction with the metal complex.

The precursor polymer can be produced in accordance with the publicly known production process of diaryl and polyarylene. However, a production process high in yield and purity of a product is preferably used. More specifically, a process, in which a pyridine derivative having 2 leaving groups, such as a dihalide, dimethanesulfonate, di-trifluoromethanesulfonate, diacetate, diborate or distannane of a pyridine derivative is condensed in the presence of a transition metal catalyst such as Ni, Pd or Pt and an organic solvent, adding a reducing agent, alkali metal iodide or triarylphosphine as needed, is preferably used.

In the process of condensing the pyridine derivative having 2 leaving groups, a copolymer containing both structural unit of the general formula (2) and arylene group can be produced by causing a copolymerizable monomer component composed of another aromatic compound than the pyridine derivative to coexist together with the pyridine derivative. The copolymer obtained in such a manner may also be used as a precursor polymer for the polymeric phosphorescent agent according to the present invention.

As examples of the copolymerizable monomer component, may be mentioned dihalides, dimethanesulfonates, ditrifluoromethanesulfonates, diacetates, diborates and distannanes of arylene derivatives such as phenylene, biphenylene, fluorene, bisphenyleneoxadiazole and bisphenylenealkylcarbazole.

These processes can be performed in accordance with the production process of a polyfluorene derivative described in Q. Pei, Y. Yang, J. Am. Chem. Soc., Vol. 118, p. 7416, 1996, R. Maxime, R. Dany, L. Mario, Macromolecules, Vol. 30, p. 7686, 1997, etc.

In the process described above, the low-molecular compound having 2 leaving groups is used as a starting material. However, for example, a high-molecular weight compound obtained by polymerizing a low-molecular compound having 2 leaving groups in advance, or a block polymer obtained by bonding at least 2 kinds of high-molecular weight compounds may also be used as a starting material.

As the precursor metal complex, is used a low-molecular metal complex having a metal atom selected from Pd, Pt, Rh, Ir, Ru, Os and Re as a central metal. A low-molecular metal complex the central metal of which is Ir, Os or Pt is preferably used.

As such metal complexes, may be mentioned mononuclear complexes represented by the general formula (3).

In the general formula (3), M is a metal atom having a valence of 2 to 4. Specifically, M is selected

from Pd, Pt, Rh, Ir, Ru, Os and Re.

L is an organic ligand similar to the general formula (1) and selected from organic compounds having coordination property to the metal atom M.

Q is a ligand, the whole or part of which is left by the reaction with the precursor polymer. Specifically, Q is selected from monovalent or still higher ligands such as halogen atoms, a hydrogen atom, alkoxide groups, alkyl groups, an acetylacetonate group and a carbonyl group.

x is an integer of 1 to 4, and each of y and z is, independently, an integer of 0 to 8.

The luminescent composition according to the present invention is a composition comprising the polymeric phosphorescent agent described above, a hole-transporting polymer and an organic solvent and is suitable for use in an organic electroluminescence device.

As the hole-transporting polymer, may be preferably used a copolymer of N-vinylcarbazole and a vinyl-substituted 1-oxa-3,4-diazole compound.

As the organic solvent, may be used an organic solvent usable in the production of the polymeric phosphorescent agent according to the present invention.

As preferable examples of the organic solvent making up the luminescent composition according to the present invention, may be mentioned ethyl lactate, propylene glycol monomethyl ether, propylene glycol monomethyl acetate and cyclohexanone.

The organic electroluminescence device that is a one of the applied product according to the present invention will hereinafter be described.

Fig. 1 is a cross-sectional view illustrating the construction of the organic electroluminescence device according to the present invention.

In this EL device, an anode layer 2 is provided on a transparent substrate 1. A hole-transporting layer 3 is provided on this anode layer 2. A copper phthalocyanine layer 4 is further provided on the hole-transporting layer 3. A'luminescent layer 5 is provided on the copper phthalocyanine layer 4, and an electron-injecting layer 6 is provided on the luminescent layer 5. A cathode layer 7 is provided on this electron-injecting layer 6. This cathode layer 7 is also called an electron-injecting electrode layer. The anode layer 2 and the cathode layer 7 are connected to a DC power source 10.

As the transparent substrate 1, may be used a glass substrate, transparent resin substrate, quartz glass substrate or the like.

The anode layer 2 is also called a hole- injecting electrode layer, and that composed of a material having a work function as high as, for example, at least 4 eV is preferably used. In the present invention, the "work function" means the magnitude of minimum work required to take out an electron from a solid into a vacuum.

As the anode layer 2, may be used, for example, an ITO (indium tin oxide) film, tin oxide ($SnO_2$) film, copper oxide (CuO) film or zinc oxide (ZnO) film.

The hole-transporting layer 3, which is also called a hole-injecting layer is provided for the purpose of efficiently supplying a hole to the luminescent layer 5 and adapted to receive the hole from the anode layer 2 and transport it to the luminescent layer 5 through the copper phthalocyanine layer 4.

As a material for forming the hole-transporting layer 3, may be used an aromatic polymer, preferably PEDOT (poly(3,4)-ethylenedioxythiophene-polystyrenesulfonate) Besides, 1,1-bis(4-di-p-aminophenyl)cyclohexane, a triphenylamine derivative, carbazole derivative or the like may also be used as the hole-transporting layer 3.

The copper phthalocyanine layer 4, i.e., a layer composed of CuPC is provided between the hole-transporting layer 3 and the luminescent layer 5, whereby an energy barrier between the hole-transporting layer 3 and the luminescent layer 5 can be reduced. The injection of the hole into the luminescent layer 5 can thereby be smoothly conducted, so that energy matching between the hole-transporting layer 3 and the luminescent layer 5 can be easily taken.

Accordingly, an organic EL device having such a copper phthalocyanine layer 4 comes to realize a long life and have high luminous efficiency and excellent durability.

The luminescent layer 5 is a layer where an electron is bonded to a hole to emit the bonding energy thereof as light. As a material for forming this luminescent layer 5, may be used a material containing the polymeric phosphorescent agent according to the present invention.

Such a luminescent layer 5 can be formed by, for example, applying the luminescent composition according to the present invention to a surface of a substrate, on which the luminescent layer 5 should be formed, and subjecting the applied composition to a heating treatment.

The electron-injecting layer 6 is a layer adapted to receive an electron from the cathode layer 7 and transport it to the luminescent layer 5.

As a material for forming the electron-injecting layer 6, is preferably used a bathophenanthroline material (BPCs). Besides, an anthraquinodimethane derivative, diphenylquinone derivative, oxadiazole derivative, perylenetetracarboxylic acid derivative or the like may also be used.

As the cathode layer 7, may be used that composed of a material having a work function as low as, for example, at most 4 eV.

Specific examples of the material forming the cathode layer 7 include metal films composed of aluminum, calcium, magnesium, lithium or indium and alloy films of these metals.

In the organic EL device of such a structure, when direct current voltage is applied between the anode layer 2 and the cathode layer 7 by the DC power

source 10, the luminescent layer 5 emits light, and the light is radiated through the anode layer 2 and transparent substrate 1.

In particular, since the copper phthalocyanine layer 4 is provided between the hole-transporting layer 3 and the luminescent layer 5 in this organic EL device, the energy barrier between the hole-transporting layer 3 and the luminescent layer 5 is reduced, so that injection of a hole into the luminescent layer is smoothly conducted. Therefore, this organic EL device exhibits high luminous efficiency and excellent durability.

## BRIEF DESCRIPTION OF THE DRAWING

Fig. 1 illustrates the construction of an organic electroluminescence device according to the present invention.

[Description of Characters]

| | |
|---|---|
| 1 | Transparent substrate |
| 2 | Anode layer |
| 3 | Hole-transporting layer |
| 4 | Copper phthalocyanine layer |
| 5 | Luminescent layer |
| 6 | Electron-injecting layer |
| 7 | Cathode layer |
| 10 | DC power source |

## BEST MODE FOR CARRYING OUT THE INVENTION

The embodiments of the present invention will hereinafter be described. However, the present invention is not limited thereby.

<Preparation Example 1 of Precursor Polymer>

A flask purged with nitrogen was charged with 9.86 g (18. 0 mmol) of 2,7-dibromo-9,9-dioctylfluorene, 0.47 g (2.0 mmol) of 2,5-dibromopyridine, 0.26 g (2.0 mmol) of anhydrous nickel chloride, 3.14 g (12.0 mmol) of triphenylphosphine, 1.50 g (10.0 mmol) of sodium iodide, 9.16 g (140.0 mmol) of zinc powder and 50 ml of anhydrous N-methylpyrrolidone, and the mixture was heated and stirred at 85°C for 30 hours. After this reaction system was cooled, the resultant reaction mixture was poured into a methanol solution of hydrochloric acid to isolate a polymer as a precipitate. Thereafter, a chloroform solution of this polymer was obtained. The polymer thus formed was washed first with diluted hydrochloric acid and then with a dilute alkali solution, filtered, washed with a saturated aqueous solution of potassium carbonate, dried over anhydrous potassium carbonate and then filtered. Purified magnesium silicate powder (60-100 mesh, trade name "Furosi") was added to the resultant filtrate, and the mixture was filtered, concentrated and then reprecipitated with methanol to conduct purification, thereby obtaining a copolymer of the pyridine derivative condensed with the dioctylfluorene at 2- and 5-positions of the pyridine ring as 3.6 g of yellow powder.

The weight average molecular weight of the copolymer thus obtained was determined by means of GPC and found to be 8,200. This copolymer is called "Precursor Polymer (1)".

<Preparation Example 2 of Precursor Polymer>

A flask purged with nitrogen was charged with 9.86 g (18. 0 mmol) of 2,7-dibromo-9,9-dioctylfluorene, 0.47 g (2.0 mmol) of 2,6-dibromopyridine, 0.26 g (2.0 mmol) of anhydrous nickel chloride, 3.14 g (12.0 mmol) of triphenylphosphine, 1.50 g (10.0 mmol) of sodium iodide, 9.16 g (140.0 mmol) of zinc powder and 50 ml of anhydrous N-methylpyrrolidone, and the mixture was heated and stirred at 85°C for 30 hours. After this reaction system was cooled, the resultant reaction mixture was poured into a methanol solution of hydrochloric acid to isolate a polymer as a precipitate. Thereafter, a chloroform solution of this polymer was obtained. The polymer thus formed was washed first with diluted hydrochloric acid and then with a dilute alkali solution, filtered, washed with a saturated aqueous solution of potassium carbonate, dried over anhydrous potassium carbonate and then filtered. Purified magnesium silicate powder (60-100 mesh, trade name "Furosi") was added to the resultant filtrate, and the mixture was filtered, concentrated and then reprecipitated with methanol to conduct purification, thereby obtaining a copolymer of the pyridine derivative condensed with the dioctylfluorene at 2- and 6-positions of the pyridine ring as 4.5 g of yellow powder.

The weight average molecular weight of the copolymer thus obtained was determined by means of GPC and found to be 12,000. This copolymer is called "Precursor Polymer (2)".

<Preparation Example 3 of Precursor Polymer>

A flask purged with nitrogen was charged with 10.14 g (18. 5 mmol) of 2,7-dibromo-9,9-dioctylfluorene, 0.14 g (0.9 mmol) of 2-bromopyridine, 0.26 g (2.0 mmol) of anhydrous nickel chloride, 3.14 g (12.0 mmol) of triphenylphosphine, 1.50 g (10.0 mmol) of sodium iodide, 9.16 g (140.0 mmol) of zinc powder and 60 ml of anhydrous N-methylpyrrolidone, and the mixture was heated and stirred at 85°C for 30 hours. After this reaction system was cooled, the resultant reaction mixture was poured into a methanol solution of hydrochloric acid to isolate a polymer as a precipitate. Thereafter, a chloroform solution of this polymer was obtained. The polymer thus formed was washed first with diluted hydrochloric acid and then with a dilute alkali solution, filtered, washed with a saturated aqueous solution of potassium

carbonate, dried over anhydrous potassium carbonate and then filtered. Purified magnesium silicate powder (60-100 mesh, trade name "Furosi") was added to the resultant filtrate, and the mixture was filtered, concentrated and then reprecipitated with methanol to conduct purification, thereby obtaining a polymer composed of poly(dioctylfluorene) having a 2-pyridyl group at a terminal thereof as 5.2 g of pale yellow powder.

The weight average molecular weight of the polymer thus obtained was determined by means of GPC and found to be 13,000. This polymer is called "Precursor Polymer (3)".

<Preparation Example 4 of Precursor Polymer>

A flask purged with nitrogen was charged with 5.98 g (20.0 mmol) of 2,6-bis(4-chlorophenyl)pyridine, 0.26 g (2.0 mmol) of anhydrous nickel chloride, 3.14 g (12.0 mmol) of triphenylphosphine, 1.50 g (10.0 mmol) of sodium iodide, 9.16 g (140.0 mmol) of zinc powder and 60 ml of anhydrous N-methylpyrrolidone, and the mixture was heated and stirred at 85°C for 30 hours. After this reaction system was cooled, the resultant reaction mixture was poured into a methanol solution of hydrochloric acid to isolate a polymer as a precipitate. Thereafter, a chloroform solution of this polymer was obtained. The polymer thus formed was washed first with diluted hydrochloric acid and then with a dilute alkali solution, filtered, washed with a saturated aqueous solution of potassium carbonate, dried over anhydrous potassium carbonate and then filtered. Purified magnesium silicate powder (60-100 mesh, trade name "Furosi") was added to the resultant filtrate, and the mixture was filtered, concentrated and then reprecipitated with methanol to conduct purification, thereby obtaining a polymer composed of polybiphenylenepyridine as 4.1 g of pale yellow powder.

The weight average molecular weight of the polymer thus obtained was determined by means of GPC and found to be 11,000. This polymer is called "Precursor Polymer (4)".

<Preparation Example 5 of Precursor Polymer>

A flask purged with nitrogen was charged with 10.14 g (18. 5 mmol) of 2,7-dibromo-9,9-dioctylfluorene, 0.27 g (0.9 mmol) of 2,6-bis(4-chlorophenyl)pyridine, 0.26 g (2.0 mmol) of anhydrous nickel chloride, 3.14 g (12.0 mmol) of triphenylphosphine, 1.50 g (10.0 mmol) of sodium iodide, 9.16 g (140.0 mmol) of zinc powder and 60 ml of anhydrous N-methylpyrrolidone, and the mixture was heated and stirred at 85°C for 30 hours. After this reaction system was cooled, the resultant reaction mixture was poured into a methanol solution of hydrochloric acid to isolate a polymer as a precipitate. Thereafter, a chloroform solution of this polymer was obtained. The polymer thus formed was washed first with diluted hydrochloric acid and then with a dilute alkali solution, filtered, washed with a saturated aqueous solution of potassium carbonate, dried over anhydrous potassium carbonate and then filtered. Purified magnesium silicate powder (60-100 mesh, trade name "Furosi") was added to the resultant filtrate, and the mixture was filtered, concentrated and then reprecipitated with methanol to conduct purification, thereby obtaining a copolymer of polybiphenylenepyridine and dioctylfluorene as 5.0 g of pale yellow powder.

The weight average molecular weight of the copolymer thus obtained was determined by means of GPC and found to be 9,000. This copolymer is called "Precursor Polymer (5)".

<Preparation Example 1 of Precursor Metal Complex>

With 2.9 g (10 mmol) of iridium (III) chloride hydrate were mixed 3.50 g (22.6 mmol) of phenylpyridine and 100 g of hydrous methoxyethanol, and the mixture was heated and stirred at 120°C for 10 hours under a nitrogen stream. The solution thus obtained was cooled, and crystals deposited were separated by filtration and vacuum-dried, thereby obtaining 5.41 g (5.1 mmol) of a chlorobis(2-phenylpyridine) iridium (III) dimmer. This metal complex is called "Precursor Metal Complex (1)".

<Preparation Example 2 of Precursor Metal Complex>

To 1.0 g (0.93 mmol) of the above-described chlorobis(2-phenylpyridine) iridium (III) dimmer were added 0.1 g (1 mmol) of acetylacetone and 10 g of methoxyethanol, and the mixture was heated and stirred at 70°C for 10 hours under a nitrogen stream. The solution thus obtained was cooled, and crystals deposited were separated by filtration and vacuum-dried, thereby obtaining 0.8 g (1.4 mmol) of bis(2-phenylpyridine)acetylacetonatoiridium (III). This metal complex is called "Precursor Metal Complex (2)".

<Preparation Example 3 of Precursor Metal Complex>

To 1.0 g (0.79 mmol) of a chlorobis(2-(2,4-difluoro)phenyl-4-methylpyridine) iridium (III) dimmer were added 0.1 g (1 mmol) of acetylacetone and 10 g of methoxyethanol, and the mixture was heated and stirred at 120°C for 10 hours under a nitrogen stream. The solution thus obtained was cooled, and crystals deposited were separated by filtration and vacuum-dried, thereby obtaining 0.7 g (1.0 mmol) of bis(2-(2,4-difluoro)phenyl-4-methylpyridine)acetylacetonatoiridium (III). This metal complex is called "Precursor Metal Complex (3)".

<Preparation Example 4 of Precursor Metal Complex>

To 1.0 g (0.78 mmol) of a chlorobis(2-phenylquinoline) iridium (III) dimmer were added 0.1 g (1 mmol) of acetylacetone and 10 g of methoxyethanol, and the mixture was heated and stirred at 120°C for 10

hours under a nitrogen stream. The solution thus obtained was cooled, and crystals deposited were separated by filtration and vacuum-dried, thereby obtaining 0.7 g (1.0 mmol) of bis(2-phenylquinoline)acetylacetonatoiridium (III). This metal complex is called "Precursor Metal Complex (4)".

<Preparation Example 1 of Polymeric Phosphorescent Agent>

After a solution composed of 2.0 g of Precursor Polymer (1), 0.15 g of Precursor Metal Complex (1) and 50 ml of tetrahydrofuran was refluxed for 6 hours under a nitrogen stream, cooling, reprecipitation with methanol and purification were conducted, thereby obtaining a polymeric phosphorescent agent wherein $R^1$ and $R^2$ in the general formula (1) are both hydrogen atoms, M is Ir, p is 2, and L is ortho-metallation-coordinated phenylpyridine. This polymeric phosphorescent agent is called "Polymeric Phosphorescent Agent (1)".

A chloroform solution of Polymeric Phosphorescent Agent (1) thus obtained exhibited a phosphorescence spectrum of green.

<Preparation Example 2 of Polymeric Phosphorescent Agent>

After a solution composed of 2.0 g of Precursor Polymer (2), 0.15 g of Precursor Metal Complex (2) and 50 ml of tetrahydrofuran was refluxed for 6 hours under a nitrogen stream, cooling, reprecipitation with methanol and purification were conducted, thereby obtaining a polymeric phosphorescent agent wherein $R^1$ and $R^2$ in the general formula (1) are both hydrogen atoms, M is Ir, p is 2, and L is ortho-metallation-coordinated phenylpyridine. This polymeric phosphorescent agent is called "Polymeric Phosphorescent Agent (2)".

A chloroform solution of Polymeric Phosphorescent Agent (2) thus obtained exhibited a phosphorescence spectrum of green.

<Preparation Example 3 of Polymeric Phosphorescent Agent >

After a solution composed of 2.0 g of Precursor Polymer (3), 0.15 g of Precursor Metal Complex (3) and 50 ml of tetrahydrofuran was refluxed for 6 hours under a nitrogen stream, cooling, reprecipitation with methanol and purification were conducted, thereby obtaining a polymeric phosphorescent agent wherein $R^1$ and $R^2$ in the general formula (1) are both hydrogen atoms, M is Ir, p is 2, and L is ortho-metallation-coordinated 2-(2,4-difluoro)phenyl-4-methylpyridine. This polymeric phosphorescent agent is called "Polymeric Phosphorescent Agent (3)".

A chloroform solution of Polymeric Phosphorescent Agent (3) thus obtained exhibited a phosphorescence spectrum of blue.

<Preparation Example 4 of Polymeric Phosphorescent Agent >

After a solution composed of 2.0 g of Precursor Polymer (4), 0.15 g of Precursor Metal Complex (4) and 50 ml of tetrahydrofuran was refluxed for 6 hours under a nitrogen stream, cooling, reprecipitation with methanol and purification were conducted, thereby obtaining a polymeric phosphorescent agent wherein $R^1$ and $R^2$ in the general formula (1) are both hydrogen atoms, M is Ir, p is 2, and L is ortho-metallation-coordinated 2-phenylquinoline. This polymeric phosphorescent agent is called "Polymeric Phosphorescent Agent (4)".

A chloroform solution of Polymeric Phosphorescent Agent (4) thus obtained exhibited a phosphorescence spectrum of red.

<Preparation Example 5 of Polymeric Phosphorescent Agent >

After a solution composed of 2.0 g of Precursor Polymer (5), 0.15 g of Precursor Metal Complex (4) and 50 ml of tetrahydrofuran was refluxed for 6 hours under a nitrogen stream, cooling, reprecipitation with methanol and purification were conducted, thereby obtaining a polymeric phosphorescent agent wherein $R^1$ and $R^2$ in the general formula (1) are both hydrogen atoms, M is Ir, p is 2, and L is ortho-metallation-coordinated 2-phenylquinoline. This polymeric phosphorescent agent is called "Polymeric Phosphorescent Agent (5)".

A chloroform solution of Polymeric Phosphorescent Agent (5) thus obtained exhibited a phosphorescence spectrum of red.

A production process of an organic electroluminescence device making use of each of Polymeric Phosphorescent Agent (1) to Polymeric Phosphorescent Agent (5) thus obtained as a luminescent material and evaluation results will hereinafter be described.

<Production Example of Organic Electroluminescence Device>

A solution composed of 16.4 g (85 mmol) of N-vinylcarbazole, 4.86 g (15 mmol) of 2-biphenyl-5(p-vinylphenyl)-1-oxa-3,4-diazole, 0.033 g (0.2 mmol) of 2,2'-azobisisobutyronitrile and 63.8 g of dimethylformamide was first prepared. This solution was heated and stirred at 70°C for 12 hours under a nitrogen atmosphere, thereby conducting polymerization. The resultant reaction solution was poured into methanol to solidify and vacuum-dry a reaction product, thereby isolating a copolymer (hereinafter referred to as "Polymer (A)"). The weight average molecular weight of this Polymer (A) was determined by means of GPC and found to be 30,000.

With 100 parts by weight of Polymer (A) thus obtained were mixed 10 parts by weight of each of Polymeric Phosphorescent Agent (1) to Polymeric Phosphorescent Agent (5), and cyclohexanone was added to this mixture system to form a solution, thereby preparing Luminescent Composition (A-1) to Luminescent Composition (A-5) each having a luminescent material concentration of 5 % by weight.

For the sake of comparison, 10 parts by weight of Precursor Polymer (1) were mixed with 100 parts by weight of Polymer (A), and cyclohexanone was added to this mixture system to form a solution, thereby preparing a composition having a precursor polymer concentration of 5 % by weight. This composition is called "Composition B-1".

A 5 % by weight solution of PEDT (trade name: "Bayer P8000" (product of Bayer Yakuhin, Ltd.)) was then applied on to a 5-cm square glass substrate, on the surface of which an ITO film had been formed. The glass substrate, to which this solution had been applied, was heated at 150°C for 30 minutes, and copper phthalocyanine was further vapor-deposited on this glass substrate.

Each of Luminescent Composition (A-1) to Luminescent Composition (A-5) and Composition (B-1) was applied on to the glass substrate, on which copper phthalocyanine had been vapor-deposited, by means of a spin coater. After the application, the applied composition was heated to 120°C over 10 minutes, thereby forming a luminescent layer.

Bathophenanthroline and Cs were vapor-deposited on the thus-formed luminescent layer so as to give a molar ratio of 1:3, thereby forming an electron-injecting layer. An aluminum electrode as a cathode was further laminated by 100 nm on the electron-injecting layer. Thereafter, sealing was conducted with glass, thereby completing Organic EL Device (1) to Organic EL Device (5) and Comparative Device (1).

Organic EL Device (1) is an organic EL device equipped with a luminescent layer composed of Luminescent Composition (A-1), Organic EL Device (2) is an organic EL device equipped with a luminescent layer composed of Luminescent Composition (A-2), Organic EL Device (3) is an organic EL device equipped with a luminescent layer composed of Luminescent Composition (A-3), Organic EL Device (4) is an organic EL device equipped with a luminescent layer composed of Luminescent Composition (A-4), Organic EL Device (5) is an organic EL device equipped with a luminescent layer composed of Luminescent Composition (A-5), and Comparative Device (1) is an EL device equipped with a luminescent layer composed of Composition (B-1).

Direct current voltage of 7V was applied to each of Organic EL Devices (1) to (5) and Comparative Device (1) produced in such a manner by using the ITO film as an anode and the aluminum film as a cathode, thereby emitting light to evaluate it as to luminescence color and luminance.

As a result, Organic EL Device (1) and Organic EL Device (2) exhibited electroluminescence of green, Organic EL Device (3) exhibited electroluminescence of blue, Organic EL Device (4) exhibited electroluminescence of red, and Organic EL Device (5) exhibited electroluminescence of red, and the luminance was 100 to 500 cd/$m^2$.

On the other hand, Comparative Device (1) exhibited weak blue at a luminance of 50 cd/$m^2$ or lower.

<u>EFFECTS OF THE INVENTION</u>

According to the polymeric phosphorescent agent of the present invention, a luminescent layer can be easily formed by a wet method such as an ink-jet method, and organic electroluminescence devices having high luminance can be provided. When such a polymeric phosphorescent agent is used to form a luminescent layer of an organic electroluminescence device by a wet method, good coating property and excellent luminance are achieved, and luminescence of a wide range from red to blue can be achieved.

According to the polymeric phosphorescent agent of the present invention, a polymeric phosphorescent agent, by which a luminescent layer can be easily formed by a wet method such as an ink-jet method, and an organic electroluminescence device having high luminance can be provided, can be produced.

The luminescent composition according to the present invention can provide an organic electroluminescence device high in both luminance and luminous efficiency because it contains the polymeric phosphorescent agent described above.

According to the organic electroluminescence device, which is an applied product of the present invention, excellent luminance and luminous efficiency can be achieved because it has a luminescent layer composed of a material containing the polymeric phosphorescent agent described above.

**Claims**

1. A polymeric phosphorescent agent comprising a structural unit represented by the following general formula (1):

General formula (1)

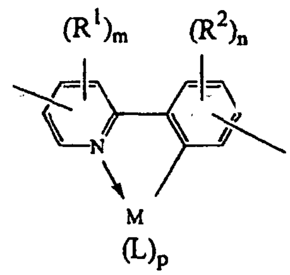

wherein M is a metal atom having a valence of 2 to 4, each of $R^1$ and $R^2$ is, independently, a monovalent substituent selected from a hydrogen atom, halogen atoms, alkyl groups and aryl groups, L is an organic ligand, each of m and n is, independently, an integer of 1 to 3, and p is an integer of 1 to 4, in its molecule and having a molecular weight of at least 500.

**2.** The polymeric phosphorescent agent according to claim 1, wherein the molecular weight thereof is 500 to 50,000.

**3.** The polymeric phosphorescent agent according to claim 1 or 2, wherein M indicating the metal atom in the general formula (1) is a metal atom selected from the group consisting of Pd, Pt, Rh, Ir, Ru, Os and Re.

**4.** A process for producing the polymeric phosphorescent agent according to any one of claims 1 to 3, which comprises reacting a polymer having a structural unit represented by the following general formula (2):

General formula (2)

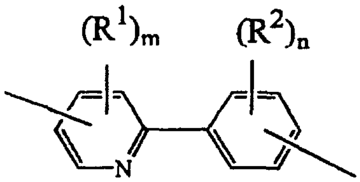

wherein each of $R^1$ and $R^2$ is, independently, a monovalent substituent selected from a hydrogen atom, halogen atoms, alkyl groups and aryl groups, and each of m and n is, independently, an integer of 1 to 3, in its molecule with a metal complex.

**5.** The production process of the polymeric phosphorescent agent according to claim 4, wherein the metal complex is a mononuclear complex represented by the following general formula (3):

General formula (3)

$$M_x(L)_y(Q)_z$$

wherein M is a metal atom having a valence of 2 to 4, L is an organic ligand, Q is a ligand, the whole or part of which is left by the reaction with the polymer containing the structural unit represented by the general formula (2) in its molecule, x is an integer of 1 to 4, and each of y and z is, independently, an integer of 0 to 8.

**6.** The production process of the polymeric phosphorescent agent according to claim 4 or 5, wherein the polymer having the structural unit represented by the general formula (2) in its molecule is obtained by condensation of a pyridine derivative having 2 leaving groups in the presence of a transition metal catalyst and an organic solvent.

**7.** A luminescent composition comprising the polymeric phosphorescent agent according to any one of claims 1 to 3, a hole-transporting polymer and an organic solvent.

**8.** The luminescent composition according to claim 7, wherein the hole-transporting polymer is a copolymer of N-vinylcarbazole and a vinyl-substituted 1-oxa-3,4-diazole compound.

**9.** The luminescent composition according to claim 7 or 8, which is suitable for use in an organic electroluminescence device.

**10.** An organic electroluminescence device comprising at least an anode layer, a luminescent layer obtained from a material containing the polymeric phosphorescent agent according to any one of claims 1 to 3 and a cathode layer.

**11.** The organic electroluminescence device according to claim 10, which is obtained by laminating the anode layer, a hole-transporting layer, a copper phthalocyanine layer and the luminescent layer in this order.

**12.** The organic electroluminescence device according to claim 10 or 11, which has a luminescent layer composed of the luminescent composition according to claim 7 or 8.

**13.** An organic electroluminescence device obtained through a step of forming a luminescent layer by applying the luminescent composition according to claim 7 or 8 to a surface of a substrate, on which the luminescent layer should be formed, and subjecting the applied composition to a heating treatment.

図 1

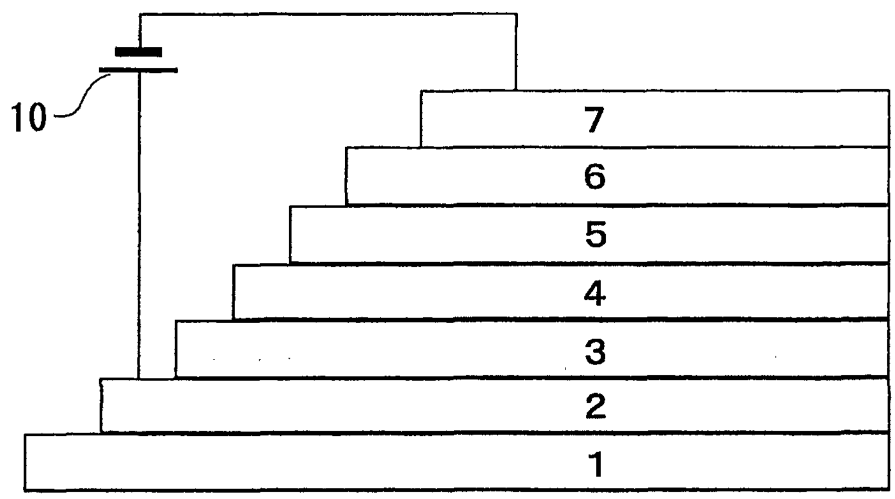

## INTERNATIONAL SEARCH REPORT

International application No.
PCT/JP03/02206

A. CLASSIFICATION OF SUBJECT MATTER
Int.Cl[7] C09K11/06, H05B33/14, C08G61/12

According to International Patent Classification (IPC) or to both national classification and IPC

B. FIELDS SEARCHED

Minimum documentation searched (classification system followed by classification symbols)
Int.Cl[7] C09K11/06, H05B33/14, C08G61/12

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | WO 03/1616 A2 (Showa Denko Kabushiki Kaisha), 03 January, 2003 (03.01.03), & JP 2003-77675 A | 1-3,9 |
| E,X | JP 2003-73480 A (Canon Inc.), 12 March, 2003 (12.03.03), Claims; Par. Nos. [0041] to [0047], [0064] (Family: none) | 1-3,7,9 |
| P,X | JP 2002-302671 A (Fuji Photo Film Co., Ltd.), 18 October, 2002 (18.10.02), Claims; page 7 (Family: none) | 1-3,9 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 May, 2003 (12.05.03) | 27 May, 2003 (27.05.03) |
| Name and mailing address of the ISA/ Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP03/02206

C (Continuation). DOCUMENTS CONSIDERED TO BE RELEVANT

| Category* | Citation of document, with indication, where appropriate, of the relevant passages | Relevant to claim No. |
|---|---|---|
| Y | US 2002/22149 A1 (Teruichi WATANABE), 21 February, 2002 (21.02.02), & JP 2001-313177 A | 1-7,9-13 |
| Y | US 5529853 A1 (Sanyo Electric Co., Ltd.), 25 June, 1996 (25.06.96), & JP 6-283268 A | 1-7,9-13 |
| Y | JP 6-1832 A (Nissan Motor Co., Ltd.), 11 January, 1994 (11.01.94), Claims; Par. Nos. [0002], [0011], [0012] (Family: none) | 1-7,9-13 |
| Y | JP 3-289090 A (Mitsui Toatsu Chemicals, Inc.), 19 December, 1991 (19.12.91), Claims; page 2, lower right column, lines 11 to 17 (Family: none) | 7 |
| Y | JP 2000-252072 A (Honda Motor Co., Ltd.), 14 September, 2000 (14.09.00), Claims; Par. Nos. [0057], [0058] (Family: none) | 7 |
| Y | JP 2001-313178 A (Pioneer Electronic Corp.), 09 November, 2001 (09.11.01), & US 2002/34655 A | 7 |
| A | JP 9-255725 A (Chemipro Kasei Kaisha, Ltd.), 30 September, 1997 (30.09.97), Claims 4, 9 (Family: none) | 8 |
| A | US 6007928 A1 (JSR Corp.), 28 December, 1999 (28.12.99), & JP 11-60660 A | 8 |

Form PCT/ISA/210 (continuation of second sheet) (July 1998)